(19) Europäisches Patentamt

European Patent Office

Office européen des brevets

(11) **EP 0 803 594 B1**

(12) **EUROPEAN PATENT SPECIFICATION**

(45) Date of publication and mention
of the grant of the patent:
**04.07.2001 Bulletin 2001/27**

(51) Int Cl.[7]: **C30B 23/02**, C30B 29/40

(21) Application number: **97106556.0**

(22) Date of filing: **21.04.1997**

(54) **Crystal growing substrate**

Kristallzüchtungssubstrat

Substrat pour la croissance de cristaux

(84) Designated Contracting States:
**DE FR GB**

(30) Priority: **22.04.1996 JP 9993996**

(43) Date of publication of application:
**29.10.1997 Bulletin 1997/44**

(73) Proprietors:
- **SONY CORPORATION**
  **Tokyo (JP)**
- **Baikowski Japan Co., Ltd.**
  **Funabashi-shi, Chiba-ken (JP)**

(72) Inventors:
- **Miyajima, Takao**
  **Shinagawa-ku, Tokyo (JP)**
- **Bellego, Yann Le**
  **Shinagawa-ku, Tokyo (JP)**

- **Ito, Takashi, c/o Baikowski Japan Co., Ltd.**
  **Funabashi-shi, Chiba-ken (JP)**

(74) Representative: **Müller, Frithjof E., Dipl.-Ing. et al**
**Patentanwälte**
**MÜLLER & HOFFMANN,**
**Innere Wiener Strasse 17**
**81667 München (DE)**

(56) References cited:
**WO-A-92/16966**        **WO-A-95/27815**

- **PATENT ABSTRACTS OF JAPAN vol. 16, no. 93
  (C-0917), 6 March 1992 & JP 03 275504 A
  (NIPPON TELEGR & TELEPH CORP.)**
- **MATERIALS RESEARCH BULLETIN, vol. 10, no.
  2, 1975, OXFORD GB, pages 85-90, XP002034577
  DIEHL ET AL: "crystal structure refinement of
  YAIO3, a promising laser material"**

**Description**

BACKGROUND

1. Field of the Invention:

The present invention relates to a crystal growing substrate, and more particularly to a crystal growing substrate on which a GaN system chemical compound semiconductor layer containing elements of N and at least one of Al, B, Ga and In can be epitaxially grown.

2. Background of the Invention:

A GaN system III-V family crystal allows its band gap energy to be changed in a range of 1.95 ev to 6.2 eV depending on its composition. Thus, the crystal draws attention as a luminescent material capable of emitting light of wavelengths over a wide range from green to ultraviolet.

Particularly, since a light emission diode LED of a high luminance using a material of GaN is recently realized, research over such a light emission diode LED has been done prosperously.

At present, as a substrate for growing thereon a GaN system material, a sapphire crystal ($\alpha$-$Al_2O_3$) is generally and widely utilized. However, there is such a large lattice mismatch as 16.1 % between a GaN crystal and the sapphire crystal. Further, both of them have thermal expansion coefficients different from each other. Therefore, the sapphire crystal is not necessarily best suited material for a substrate. The large lattice mismatch causes increase in dislocation density and a non-radiative center in the GaN crystal grown on the substrate and decrease in life of radiation recombination. Thus, the lattice mismatch may cause considerable influence on characteristics of various elements such as, particularly, a laser diode which requires current injection at high energy and so on.

In consequence, a 6H-SiC substrate, an Si substrate, a GaAs substrate, a ZnO substrate, an MgO substrate, an $MgAl_2O_4$ substrate and so on are discussed as a substrate capable of replacing for the sapphire substrate. However, each of the substrates has an advantage and a disadvantage in a state of crystal, and there has been proposed no excellent substrate yet that can replace for the sapphire substrate.

WO-A-9527815 (=EP-A-711853) describes a method of epitaxially growing a gallium nitride semiconductor crystal on a single crystal substrate, wherein as a substrate material a 3B group rare earth perovskite is proposed. Patent Abstracts of Japan vol.16 no. 93(C.0917) 6/3/92 described the growth of an oxide superconductor thin film on the (001) face of a $YAlO_3$-based rhombic perovskite-type single crystal.

OBJECTS AND SUMMARY OF THE INVENTION

Therefore, it is a general object of the present invention to provide a crystal growing substrate in which the aforesaid shortcomings and disadvantages encountered with the prior art can be eliminated.

More specifically, it is an object of the present invention to provide a crystal growing substrate on which epitaxial growth of GaN system materials, particularly, GaN material can be satisfactorily achieved with an excellent matching property.

This object is solved by a substrate as defined in claims 1 and 2. That is, according to the present invention, there is provided a substrate made of yttrium · aluminum perovskite (YAP) on which a first layer made of a GaN system material is directly formed.

According to the crystal growing substrate made of YAP, it is possible to grow a target semiconductor layer of the GaN system III-V family epitaxially with a satisfactory matching with the substrate, and hence a semiconductor layer grown on the substrate has a high quality and contains very little crystal defect.

The above and other objects, features, and advantages of the present invention will become apparent from the following detailed description of an illustrative embodiment thereof to be read in conjunction with the accompanying drawings, in which like reference numerals are used to identify the same or similar parts in the several views.

BRIEF DESCRIPTION OF THE DRAWINGS

FIG. 1 is a diagram showing a crystal structure of an $YAlO_3$;
FIG. 2 is a diagram showing an array of atoms on a (111)A face of the $YAlO_3$ crystal;
FIG. 3 is a diagram showing an array of atoms on the (111)B face of the $YAlO_3$ crystal;
FIG. 4 is a diagram showing a relationship between a band gap energy and a lattice constant of respective materials;

FIG. 5 is a diagram showing an X-ray reflection spectrum of a GaN crystal which is grown on the (111) face of the $YAlO_3$ crystal substrate;

FIG. 6 is a diagram showing a PL spectrum of the GaN crystal which is grown on the (111) face of the $YAlO_3$ crystal substrate;

FIG. 7 is a diagram showing an array of atoms on a (110)A face of the $YAlO_3$ crystal;

FIG. 8 is a diagram showing an array of atoms on the (110)B face of the $YAlO_3$ crystal;

FIG. 9 is a diagram showing an array of atoms on a (001)A face of the $YAlO_3$ crystal; and

FIG. 10 is a diagram showing an array of atoms on the (001)B face of the $YAlO_3$ crystal.

## DETAILED DESCRIPTION OF THE PREFERRED EMBODIMENT

An embodiment of the crystal growing substrate according to the present invention will be described.

The substrate according to the present invention is a substrate on which a semiconductor of a GaN system III-V family chemical compound can be epitaxially grown. The substrate of the present invention is particularly made of yttrium · aluminum · perovskite (YAP), i.e., a substrate of a $YAlO_3$ crystal having a perovskite-type structure.

When the semiconductor of the GaN system III-V family chemical compound is directly grown in an epitaxial fashion on the $YAlO_3$ crystal substrate of the perovskite-type structure, the semiconductor thus made generally comes to have a hexagonal crystal structure of which *c* axis is perpendicular to the substrate.

Particularly, when the semiconductor layer made of the above-described GaN system crystal is grown on faces of (111), (110), (001) of the substrate made of the $YAlO_3$ crystal having the perovskite-type structure, very satisfactorily epitaxial growth was achieved positively.

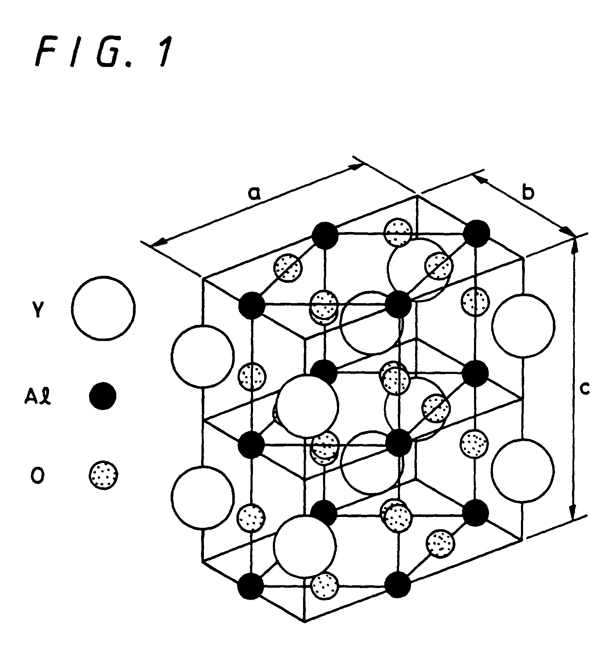

The $YAlO_3$ crystal is one of composite oxides represented by $LnAlO_3$ (here, Ln represents a rare earth element) and it is produced by combining a rare earth material with aluminum at ratio of approximately 1:1. This crystal has a perovskite-type crystal structure as shown in FIG. 1 (an orthorhombic crystal structure with lattice constants, a = 5.18 Å, b = 5.33 Å, c = 7.37 Å), and it has the following several characteristics beneficial as a substrate on which a semiconductor of the GaN system III-V family chemical compound is epitaxially grown.

That is, the $YAlO_3$ crystal has the following characteristics.

1. As will be described later on, a lattice constant of a crystal structure on a certain particular crystal face is close to that of a GaN hexagonal crystal.

2. The thermal expansion coefficient ($10 \times 10^{-6}$ /°C) is close to a thermal expansion coefficient ($5.6 \times 10^{-6}$ /°C) of the GaN hexagonal crystal.

3. As will be described later on, a crystal structure on a particular crystal face is similar to that of the GaN hexagonal crystal.

4. The melting point is such a high temperature as 1875 °C and a phase transition is not observed at a temperature below the melting point.

What is particularly important here is that the $YAlO_3$ crystal has the crystal structure and the lattice matching property described in the above items 1 and 3.

The above matter will be further inspected over the following point of view.

[1] (111) face of the $YAlO_3$ crystal

[2] (110) face of the $YAlO_3$ crystal

[3] (001) face of the $YAlO_3$ crystal

[1] Investigation on crystal growth on the (111) face of the $YAlO_3$ crystal:

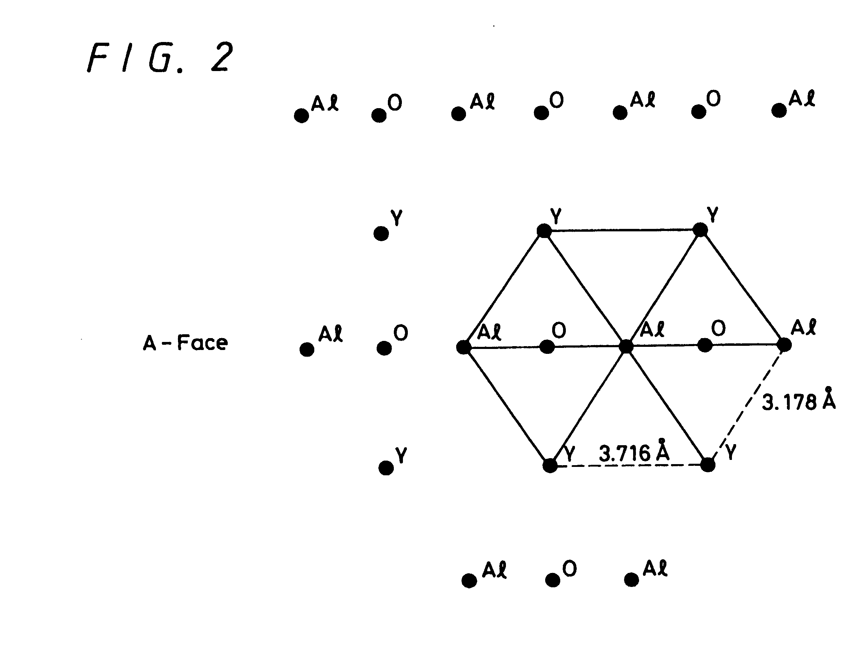

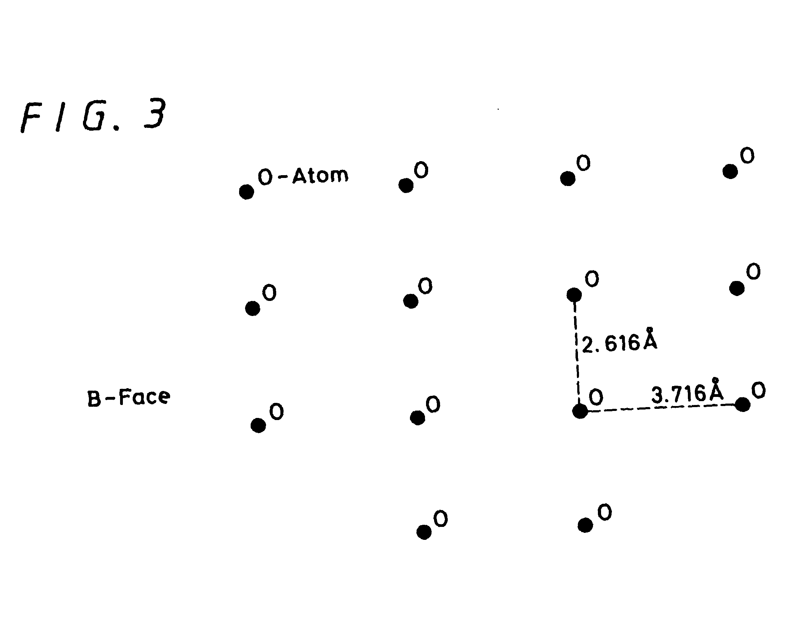

Analysis on the crystal structure using a computer revealed that the crystal on the (111) face has faces as shown in FIG. 2 and FIG. 3. The analysis on the crystal structure was performed based on a space group and reported lattice constants of the crystal, and distortion of the crystal is not taken into consideration.

That is, it was found that the crystal on the (111) face consists of lamination of three kinds of faces, i.e., an A-face in which, as shown in FIG. 2, respective atoms of Y, Al and O are present in an intermingled fashion, a B-face in which, as shown in FIG. 3, only O atoms are present, and an A'-face in which Y atoms, Al atoms and O atoms on the A face are translated so that the Y atoms overlap on the most adjacent O atoms, in the order of ABA'BABA'BA ···.

The A-face will be examined in detail. As shown in FIG. 2, the Y atoms and Al atoms on the A-face form a hexagonal shape distorted in the longitudinal direction in FIG. 2. Estimation on lengths of sides of the hexagonal shape results in, as are noted in FIG. 2, $a_1$ = 3.178 Å and $a_2$ = 3.716 Å.

On the other hand, Ga atoms (or N atoms) form a hexagonal shape on a (0001) face of the GaN hexagonal crystal. Each of the sides of this hexagonal share has the same length, a, i.e., a = 3.189 Å.

Comparison between the $YAlO_3$ crystal and GaN crystal reveal that they have the same hexagonal shape and their side lengths are similar to each other. If the Y atoms and Al atoms of the $YAlO_3$ crystal forming the hexagonal shape on the (111) A-face are combined with Ga atoms or N atoms of the GaN crystal forming on the (0001) face, then a size of the lattice mismatch $\Delta a$ between the $YAlO_3$ crystal and the GaN crystal is defined as follows;

$$\Delta a = [a\ (GaN) - a\ (substrate)] / a\ (substrate)$$

(where a (GaN) is a lattice constant of the GaN crystal and a (substrate) is a lattice constant of the substrate).

Calculation based on the above definition resulted in as follows:

$$\Delta a = 0.3\ \%\ \text{for a lattice constant } a_1 \text{ on the (111) face of the } YAlO_3 \text{ crystal.}$$

$$\Delta a = -14.2\ \%\ \text{for a lattice constant } a_2 \text{ on the (111) face of } YAlO_3 \text{ crystal.}$$

This lattice mismatch is smaller than the above-described mismatch between the GaN crystal and the sapphire substrate, i.e., 16.1 %. Particularly, the lattice mismatch $\Delta a$ for the lattice constant $a_1$ on the (111) face of the $YAlO_3$ crystal exhibits a considerably small value.

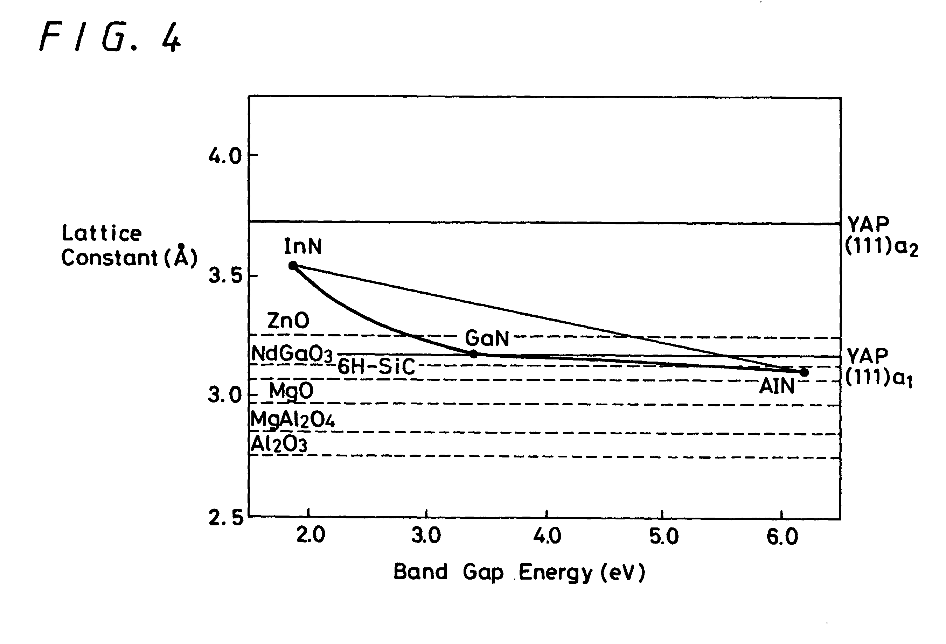

Further, the lattice mismatch $\Delta a$ for the above lattice constant $a_1$ is the closest to the lattice constant of the GaN crystal among lattice constants of various conventional crystal growing substrates, as will be understood from FIG. 4 to which reference can be made for comparing the lattice constants of the various conventional crystal growing substrates with the lattice constant of the GaN crystal.

Therefore, the whole energy yielding from the lattice mismatch between the $YAlO_3$ crystal at the (111) face and the GaN hexagonal crystal at the (0001) face comes lower than that of combination between the aforesaid sapphire substrate and the GaN crystal. Accordingly, it is understood that defect density caused by the energy resulting from the lattice mismatch can be lowered.

Actually, a GaN crystal layer was grown on the (111) face of the $YAlO_3$ crystal substrate by an MBE (Molecular Beam Epitaxy) method. Observation with an RHEED (reflective high energy electron diffraction apparatus) revealed that a streak-like pattern was generated, no twin crystal was found and two-dimensional growth was achieved. Further, it was confirmed that a crystal growing surface in this case was a mirror surface. In addition, the pitch of the streak determined by the RHEED pattern substantially coincides with the pitch of the streak pattern of the GaN crystal grown on the sapphire substrate. Therefore, it was confirmed that a hexagonal GaN single crystal was grown forming the (0001) face. Accordingly, as will be understood from the above crystal structure analysis, the crystal structure of the (0001) face of the GaN crystal is quite similar to that of the (111) face of $YAlO_3$ crystal, and hence it is understood that a GaN crystal can be formed on the $YAlO_3$ crystal substrate with relatively good lattice matching.

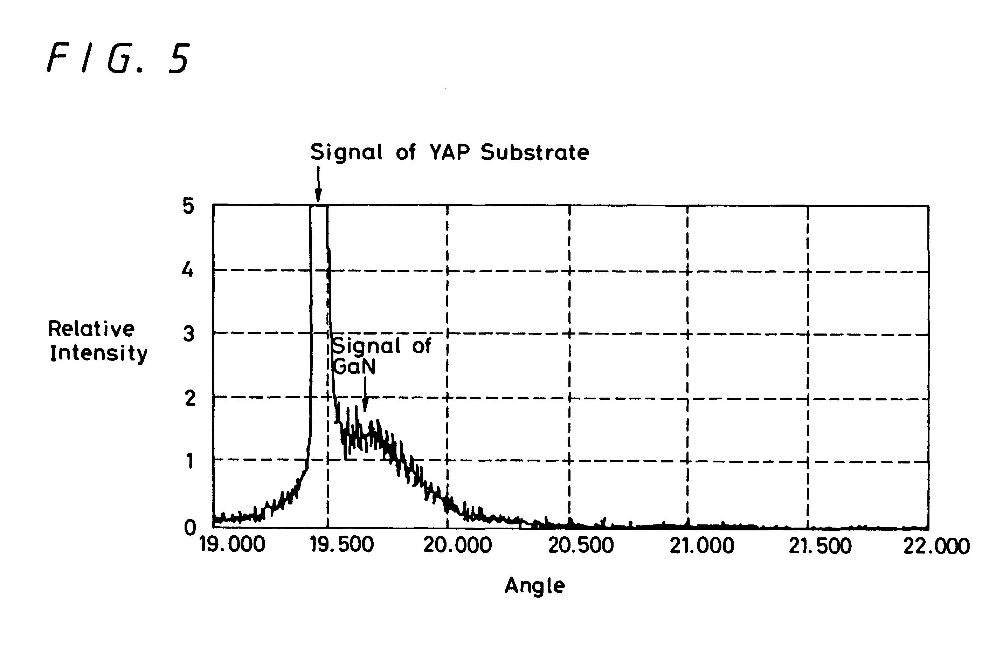

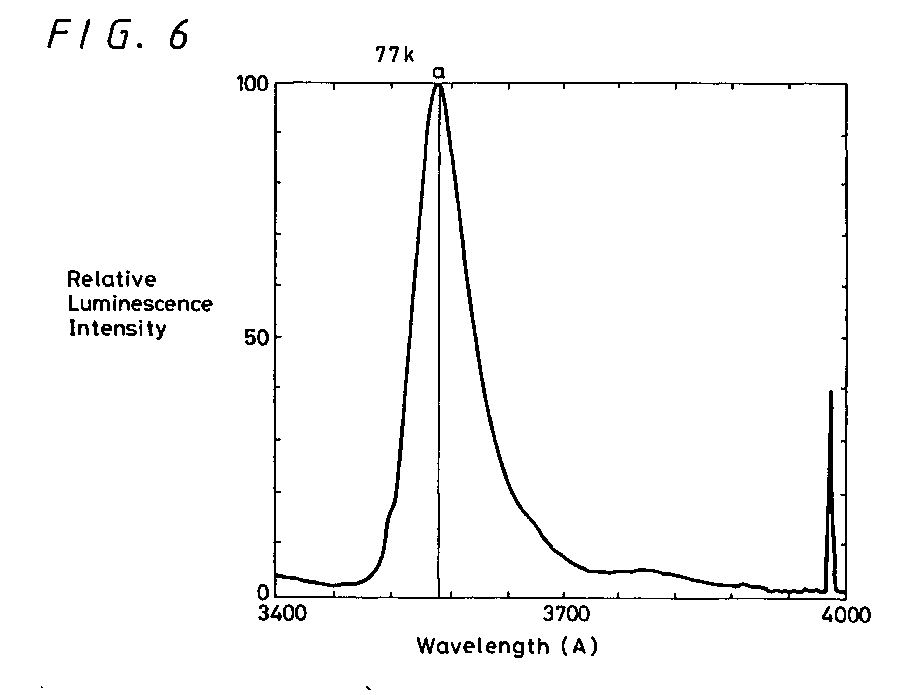

Further, in order to observe crystal property of the GaN crystal, GaN was grown on the (111) face of the above-described $YAlO_3$ substrate and its X-ray reflection spectrum and PL ( photoluminescence) spectrum were measured. FIG. 5 and FIG. 6 show the X-ray reflection spectrum and the PL spectrum, respectively. From these figures, it can be studied that these spectrums are relatively narrow in a half-width and the GaN crystal has a satisfactory crystal property. Particularly, a band-end light emission was predominant in the PL spectrum, similarly to the case of the GaN crystal formed on the sapphire substrate, and its light emission intensity from a deep level was weak. Moreover, it was confirmed that the half-width thereof was narrower than that of the GaN crystal on the sapphire substrate. Thus, it was confirmed that a GaN crystal can be grown on the $YAlO_3$ substrate with a high quality.

The GaN crystal was grown on the (111) face of the $YAlO_3$ substrate by the MBE method. In this case, the $YAlO_3$ substrate having the (111) face is bonded on a support block made of Mo through In, and the substrate supported by the block was placed in an MBE growing chamber. Then, the substrate was kept at a temperature of 300 °C for about five minutes to remove water contained in the substrate and the Mo block. Thereafter, nitrogen gas was introduced into the growing chamber. The nitrogen gas was introduced at a rate of 2 cc/min and a degree of vacuum in the growing chamber reached $1.33 \times 10^{-2}$ Pa ($1 \times 10^{-4}$ Torr). Here, ECR (Electron Cyclotron Resonance) plasma generating apparatus was driven to make nitrogen (N) into plasma. The energy of microwave supplied for generating plasma was about 40 W. The nitrogen plasma was irradiated onto the $YAlO_3$ substrate to raise the temperature of the substrate up to 850 °C. The nitrogen plasma was irradiated for about 30 minutes. Thereafter, a shutter of a Ga cell as a molecular beam source, which had been raised in its temperature in advance, was opened to apply a Ga beam and the nitrogen plasma to the $YAlO_3$ substrate at the same time to thereby growing the GaN crystal in an epitaxial fashion. The Ga beam at this time was $1.99 \times 10^{-5}$ Pa ($1.5 \times 10^{-7}$ Torr).

[2] Investigation on crystal growth on the (110) face of the $YAlO_3$ crystal:

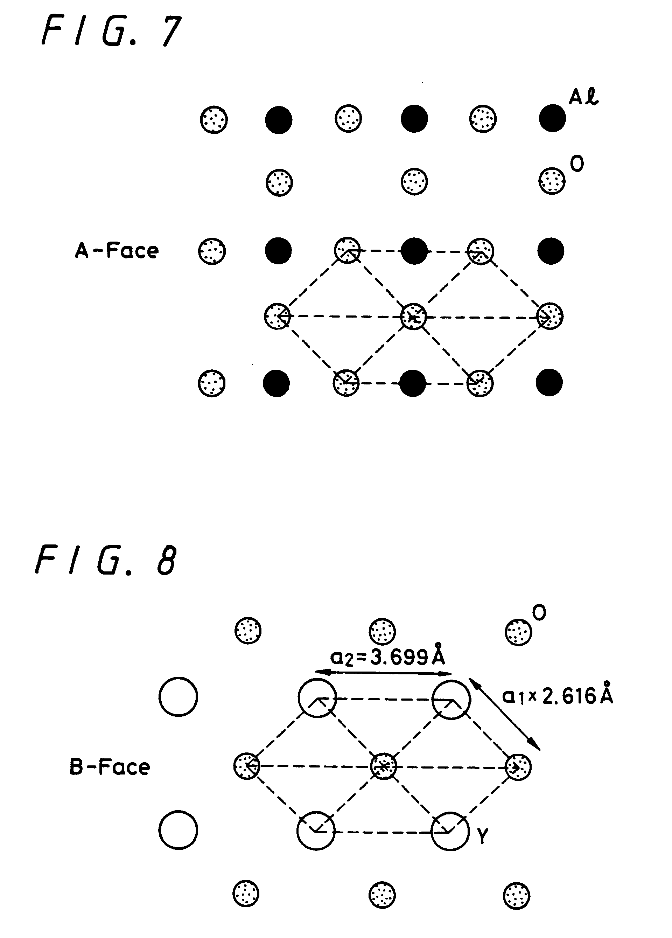

Analysis on the crystal structure using a computer revealed that the crystal of a (110) face was formed to have faces as shown in FIG. 7 and FIG. 8. That is, there was formed a lamination of two kinds of faces, i.e., an A-face in which Al atoms and O atoms are present in an intermingled fashion and a B-face in which Y atoms and O atoms are present in an intermingled fashion in the order of ABABA ···. Investigation on the B-face revealed that the Y atoms and O atoms form a hexagonal shape. This hexagonal shape also is distorted in its longitudinal direction in FIG. 7 and FIG. 8. Estimation on the sides of the hexagonal shape results in the following numerical values, as are noted in FIG. 8.

$$a_1 = 2.616 \text{ Å}$$

$$a_2 = 3.699 \text{ Å}$$

Calculation on the size of the lattice mismatch between the (110) $YAlO_3$ face and the (0001) GaN face results in the following numerical values based on the above-described equation defining the size of the lattice mismatch $\Delta a$.

$$\Delta a = +21.9 \text{ \% for the lattice constant } a_1 \text{ of the (110) } YAlO_3 \text{ face.}$$

$$\Delta a = -13.8 \text{ \% for the lattice constant } a_2 \text{ of the (110) } YAlO_3 \text{ face.}$$

The directions of the lattice mismatchings of the above lattice constants are opposite to each other and their sizes are substantially the same. Therefore, if reference is made to the fact that the size of the lattice mismatch of the GaN crystal on the sapphire substrate is isotropic and $\Delta a = 16.1$ %, a possibility is suggested that distortions of the substrate and the GaN crystal face can be relieved.

Then, a GaN crystal was grown on the (110) face of the $YAlO_3$ crystal substrate by the MBE method in a manner similar to the above-described manner that was employed for epitaxially growing the GaN crystal on the (111) face of the $YAlO_3$ crystal. Visual observation revealed that a mirror surface was grown and inspection with its RHEED revealed that a streak-like pattern was generated. Though a streak was observed on the (0001) GaN face, the kind of the streak pitch was only one. Therefore, it was understood that the GaN crystal was epitaxially grown forming the (0001) face with no twin crystal. However, since a spot was observed within the streak, it was understood that the crystal growth was achieved in a three-dimensional fashion with some unevenness rather than in a two-dimensional fashion with flatness. Accordingly, it might be difficult to achieve a crystal property of high quality such as of the GaN crystal grown on the above-described (111) $YAlO_3$ face, but it was understood that the GaN crystal can be grown forming the (0001) face on the (110) $YAlO_3$ face in an epitaxial fashion.

[3] Investigation on crystal growth on the (001) face of the $YAlO_3$ crystal:

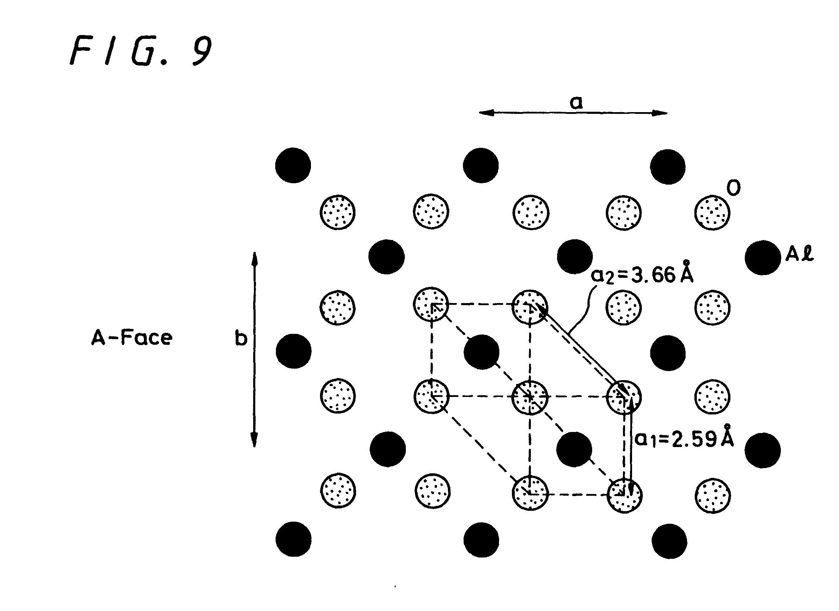

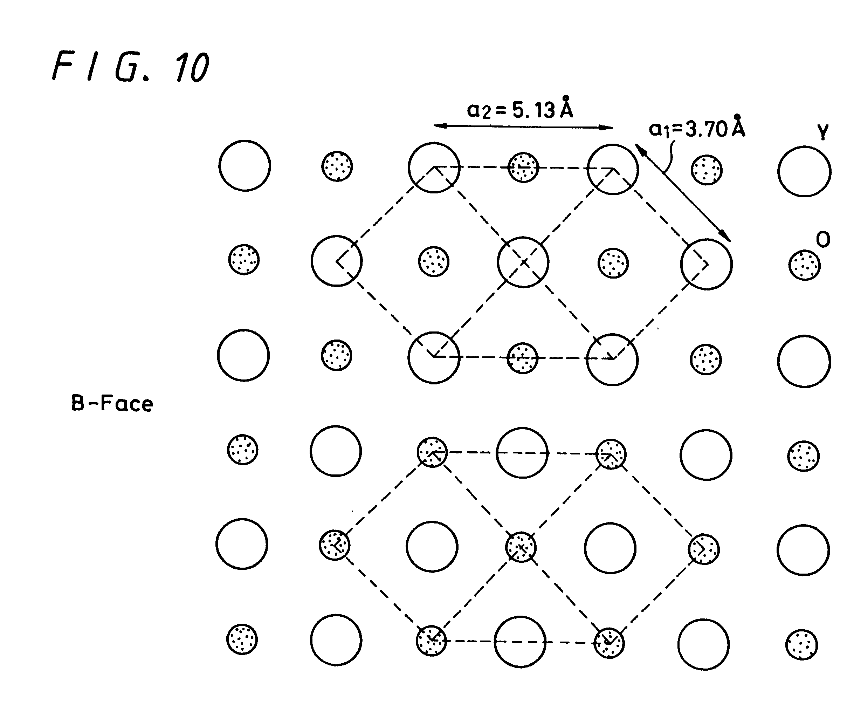

Analysis on the crystal structure using a computer revealed that the crystal of a (001) face was formed to have faces as shown in FIG. 9 and FIG. 10. That is, there was formed a lamination of two kinds of faces, i.e., an A-face in which Al atoms and O atoms were present in an intermingled fashion and a B-face in which Y atoms and O atoms were present in an intermingled fashion in the order of ABABA ···. Investigation on the A-face revealed that O atoms form a hexagonal shape. This hexagonal shape also is distorted as shown in FIG. 9 and FIG. 10. Estimation on the sides of the hexagonal shape results in the following numerical values, as are noted in FIG. 9.

$$a_1 = 2.59 \text{ Å}$$

$$a_2 = 3.66 \text{ Å}$$

Calculation on the size of the lattice mismatch between the (001) $YAlO_3$ face and the (0001) GaN face resulted in the following numerical values by using the aforesaid defining equation.

$$\Delta a = -12.9 \% \text{ for a lattice constant } a_1 \text{ of the (001) } YAlO_3 \text{ face.}$$

$$\Delta a = +23.1 \% \text{ for a lattice constant } a_2 \text{ of the (001) } YAlO_3 \text{ face.}$$

The directions of the respective lattice mismatchings are opposite to each other similarly to the case in which the aforesaid the GaN crystal is formed on the (110) $YAlO_3$ face. Therefore, the distortion of the GaN crystal face is relieved and hence, as will be described later on, a possibility is suggested that the GaN crystal can be grown forming a (0001) face on the (001) $YAlO_3$ face in an epitaxial fashion.

Then, a GaN crystal was grown on the (001) face of the $YAlO_3$ crystal substrate by the MBE in a manner similar to the above-described manner that was employed for growing the GaN crystal on the (111) $YAlO_3$ face in an epitaxial fashion. Visual observation revealed that a mirror surface was achieved and inspection with its RHEED revealed that a streak like pattern was generated. Since a streak pitch was observed on the (0001) GaN face, it is understood that the GaN crystal was epitaxially grown forming the (0001) face. However, since a spot was observed within a streak, it was understood that the crystal growth was achieved in a three-dimensional fashion with some unevenness rather than in a two-dimensional fashion with flatness, and a twin crystal was present. Accordingly, it might be difficult to achieve a crystal property of high quality that was achieved upon growing the GaN crystal on the above-described (111) $YAlO_3$ face or (110) $YAlO_3$ face. However, a possibility is suggested that the GaN crystal can be grown forming the (0001) face also on the (001) $YAlO_3$ face in an epitaxial fashion.

As described above, according to the YAP crystal substrate of the present invention, it is possible to grow a GaN system material directly on the substrate in an epitaxial fashion with an excellent crystalline property and little dislocation density.

In the present specification, each of the crystal faces of (111), (110), (001) includes a face tilted from each crystal face within a range that keeps substantially the same characteristic of the crystal face.

Further, the YAP substrate according to the present invention can be doped with an impurity to have a conductivity.

As described above, according to the present invention, since the YAP crystal substrate is utilized as a crystal growing substrate, the semiconductor layer of the GaN system can be epitaxially grown with a high quality.

According to the present invention, as described above, the lattice mismatch between the substrate and the GaN semiconductor layer can be made small. Therefore, it is possible to suppress the density of dislocation generated in the GaN semiconductor layer to a low level.

Further, the YAP substrate according to the present invention can be doped with an impurity to have a conductivity. Therefore, the substrate can be used as semiconductor device substrates of various arrangements.

Having described a preferred embodiment of the invention with reference to the accompanying drawings, it is to be understood that the invention is not limited to that precise embodiment and that various changes and modifications could be effected therein by one skilled in the art without departing from the scope of the invention as defined in the appended claims.

## Claims

1.    A substrate of rare earth perovskite type crystal, on which a semiconductor layer of a GaN system material is directly and epitaxially grown, **characterized in that** said substrate is made of yttrium-aluminum-perovskite.

2.    The use of a rare earth perovskite type crystal as a substrate for epitaxial crystal growth of a semiconductor layer of a GaN system material **characterized in that** said substrate is made of yttrium-aluminum-perovskite.

## Patentansprüche

1.    Substrat aus einem Kristall seltener Erden vom Perowskit-Typ, auf dem eine Halbleiterschicht aus einem Material eines GaN-Systems direkt und epitaxisch aufgewachsen wird, **dadurch gekennzeichnet, dass** das Substrat aus Yttrium-Aluminium-Perowskit hergestellt ist.

2. Verwendung eines Kristalls seltener Erden vom Perowskit-Typ als ein Substrat für epitaxisches Kristallwachstum einer Halbleiterschicht aus einem Material eines GaN-Systems, **dadurch gekennzeichnet, dass** das Substrat aus Yttrium-Aluminium-Perowskit hergestellt ist.

**Revendications**

1. Substrat de cristal, du type perovskite, de terre rare, sur lequel on a fait croître une couche semiconductrice d'une matière du système GaN directement et par croissance épitaxiale, caractérisé en ce que ledit substrat est fait d'yttrium-aluminium-perovskite.

2. Utilisation d'un cristal, du type perovskite, de terre rare comme substrat destiné à la croissance cristalline épitaxiale d'une couche semiconductrice d'un matériau du système de GaN, caractérisée en ce que ledit substrat est fait d'yttrium-aluminium-perovskite.

# F I G. 1

FIG. 2

EP 0 803 594 B1

# F I G. 3

●O-Atom    ●O    ●O    ●O

●O    ●O    ●O    ●O

2.616Å

B-Face    ●O    ●O    ●O    3.716Å   ●O

●O    ●O

FIG. 4

# FIG. 5

Signal of YAP Substrate

Relative Intensity

Signal of GaN

Angle

EP 0 803 594 B1

FIG. 6

# F I G. 7

A-Face

Al

O

# F I G. 8

B-Face

$a_2 = 3.699 Å$

$a_1 \times 2.616 Å$

O

Y

FIG. 9

F I G. 10

$a_2 = 5.13 Å$

$a_1 = 3.70 Å$

Y

O

B-Face